# EUROPEAN PATENT APPLICATION

(11) **EP 1 441 546 A2**
(43) Date of publication of application: **28.07.2004**
(21) Application number: 04001257.7
(22) Date of filing: 21.01.2004
(51) Int. Cl.: H04N 13/00

(54) **Electroluminescence display panel and three-dimensional display apparatus**

(30) Priority: 23.01.2003 JP 2003015050
(71) Applicant: Pioneer Corporation, Tokyo-to (JP)
(72) Inventor: Uchida, Yoshihiko, c/o Pioneer Corporation, Tsurugashima-shi, Saitama (JP); Hata, Takuya, c/o Pioneer Corporation, Tsurugashima-shi, Saitama (JP); Satoh, Hideo, c/o Pioneer Corporation, Tsurugashima-shi, Saitama (JP); Yoshizawa, Atsushi, c/o Pioneer Corporation, Tsurugashima-shi, Saitama (JP); Yanagisawa, Shuuichi, c/o Pioneer Corporation, Tsurugashima-shi, Saitama (JP); Chuman, Takashi, c/o Pioneer Corporation, Tsurugashima-shi, Saitama (JP)
(74) Representative: Viering, Jentschura & Partner

(57) **Abstract**

An EL display panel capable of presenting a smaller and lighter 3D display apparatus, wherein EL element units (60, 70) including transparent electrodes (61, 71), organic EL layers (64, 74), Al electrodes (65), ITO electrodes (75) and the like are provided for either side of a light transmissive substrate (51). Thereby, a 3D stereoscopic image can be generated and displayed by superimposing a 2D image generated by the EL element unit (60) and a 2D image generated by the EL element unit (70), and controlling the brightness of each image for each pixel.

## Description

### BACKGROUND OF THE INVENTION

### 1. Field of the Invention

The present invention relates to an electroluminescence (hereinafter referred to as "EL") display panel for a use in displaying texts, pictures and images, and further relates to a three-dimensional (hereinafter referred to as "3D") display apparatus including the EL display panel.

### 2. Description of the Related Art

There is a wide spread of CRT display apparatuses, LCD apparatuses, PDP apparatuses as display apparatuses for displaying pictures, images or the like. Recently, a display panel using organic EL elements or an organic EL display apparatus using the organic EL display panel is under development. The organic EL element is constructed in such a manner that one or more organic materials emit a light when electric current flows through a thin film of organic compound that is sandwiched between two electrodes. The organic EL display apparatus has various advantages including clear and bright image display, low power consumption, wide view angle and so on, in addition to an ability of displaying images in color, because the organic EL element emits light in itself. Nowadays, some kinds of display panel using the organic EL elements, cell phones using small organic EL display panels are on the way to the market. Furthermore, televisions or monitor devices for personal computers using the organic EL display panels are under development, and predicted that they are on the market in few years.

On the other hand, conventional display apparatuses display pictures or images as two-dimensional (hereinafter referred to as "2D") planar images. However, in recent years, technologies for generating and displaying 3D stereoscopic images are under research and development, and display apparatuses employing these technologies are under development. The following technologies are presented as technologies for generating or displaying 3D stereoscopic images. That is, for example there are provided two display panels, each of which displays an image for depicting a common object between the two images, which are in turn superimposed to give a composite image by means of a half mirror. Then, the brightness of each image is changed for each pixel on the basis of the depth or the like of the object depicted. Thereby, the viewer feels the object generated by means of the half mirror as if it is a real solid material having a depth. According to this technology, even if the display apparatus reproduces electrically and optically the image, the viewer has an illusion as if the real object is before his/her eyes. That is, the viewer feels the real presence or texture of the object, particularly in the movie, the viewer feels an illusion as if the object is approaching him/her, otherwise an illusion as if the object goes away from him/her. The detail of this technology is disclosed in Japanese Patent Application Laid-Open No. 2000-115812.

In order to present the display apparatus employing the technology for generating/displaying 3D stereoscopic images (hereinafter this display apparatus is referred to as a "3D display apparatus"), at least two display panels (display panels for displaying 2D planar images) are required. Therefore in order to present the 3D display apparatus by means of the organic EL display panel, two organic EL display panels are required. This obstructs a reduction in size of the display apparatus as a whole.

Furthermore, in order to generate/display 3D stereoscopic images, it is necessary to control conditions such that images generated by two image display devices, respectively, are accurately superimposed in the pixel order. For example, in the case that a 3D image is generated/displayed by means of two organic EL display panels and a half mirror, it is necessary to control severely the positioning of these organic EL display panels or the positioning of the half mirror. Thereby, in the manufacturing process of the display apparatus, a slight misalignment during assembling components may cause degradation in the performance of the apparatus, or may reduce the yield by producing defective products.

### SUMMARY OF THE INVENTION

It is therefore an object of the invention to provide an EL display panel capable of presenting a compact or lightweight 3D display apparatus or capable of preventing a performance degradation from a misalignment during assembling components or preventing an appearance of a defective product, and to further provide a 3D display apparatus using the EL display panel.

The above object of the invention is achieved by an EL display panel including: a substrate having a light transmissive property and having a first surface and a second surface, the second surface being opposite to the first surface; a first electroluminescence element disposed on the first surface of the substrate; and a second electroluminescence element disposed on the second surface of the substrate, wherein the second electroluminescence element is formed so as to transmit light, and positioned in a place opposite to the first electroluminescence element.

The above object of the invention is achieved by a 3D display apparatus provided with: an electroluminescence display panel; a picture signal supply device for supplying picture signals to the first electroluminescence element and the second electroluminescence element of the electroluminescence display panel, respectively; and a brightness control device for controlling brightness of the first electroluminescence element or the second electroluminescence element. The electroluminescence display panel includes: a substrate having a light transmissive property and having a first surface and a second surface that is opposite to the first surface; a first electroluminescence element disposed on the first surface of the substrate; and a second electroluminescence element disposed on the second surface of the substrate, wherein the second electroluminescence element is formed so as to transmit light and positioned in a place opposite to the first electroluminescence element.

### BRIEF DESCRIPTION OF THE DRAWINGS

FIG. 1 is a cross-sectional view illustrating a construction of an EL display panel according to an embodiment of the present invention.
FIG. 2 is a cross-sectional view enlarging a part of the EL display panel according to FIG. 1.
FIG. 3 is a cross-sectional view enlarging a part of an EL display panel according to an embodiment of the present invention.
FIG. 4 is a block diagram illustrating a construction of a 3D display apparatus according to an embodiment of the present invention.
FIG. 5 is a cross-sectional view illustrating a construction of an EL display panel according to an example of the present invention.
FIG. 6 is a cross-sectional view illustrating a substrate used for manufacturing the EL display panel according to the example of the present invention.
FIG. 7 is a cross-sectional view illustrating a manufacturing stage in the manufacturing process of the EL display panel according to the example of the present invention, in that transparent electrodes are formed on either side of the substrate.
FIG. 8 is a cross-sectional view illustrating a manufacturing stage in the manufacturing process of the EL display panel according to the example of the present invention, in that an insulation layer, an organic EL layer and others are formed on one side of the substrate.
FIG. 9 is a cross-sectional view illustrating a manufacturing stage in the manufacturing process of the EL display panel according to the example of the present invention, in that a sealing lid is formed on one side of the substrate.
FIG. 10 is a cross-sectional view illustrating a construction of an EL display panel according to another example of the present invention.

### DETAILED DESCRIPTION OF THE PREFERRED EMBODIMENTS

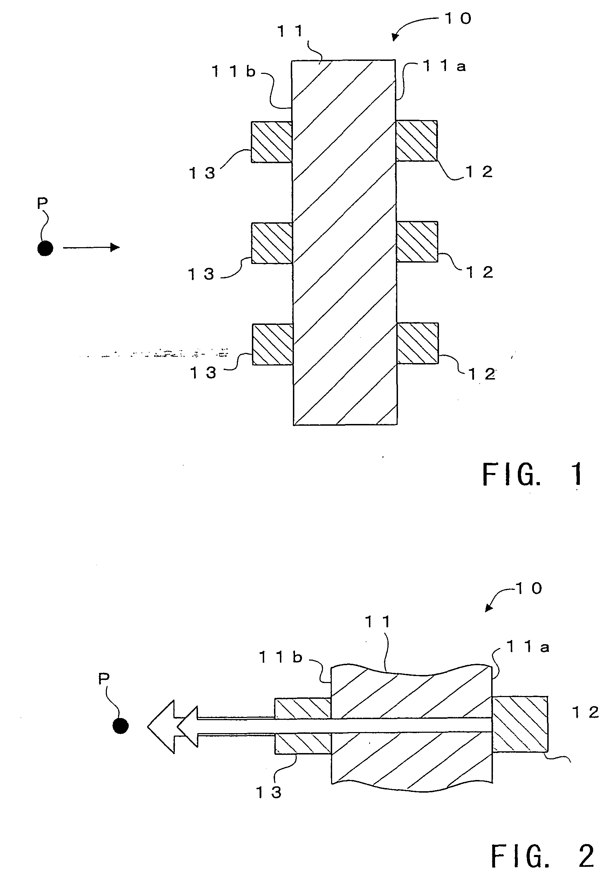

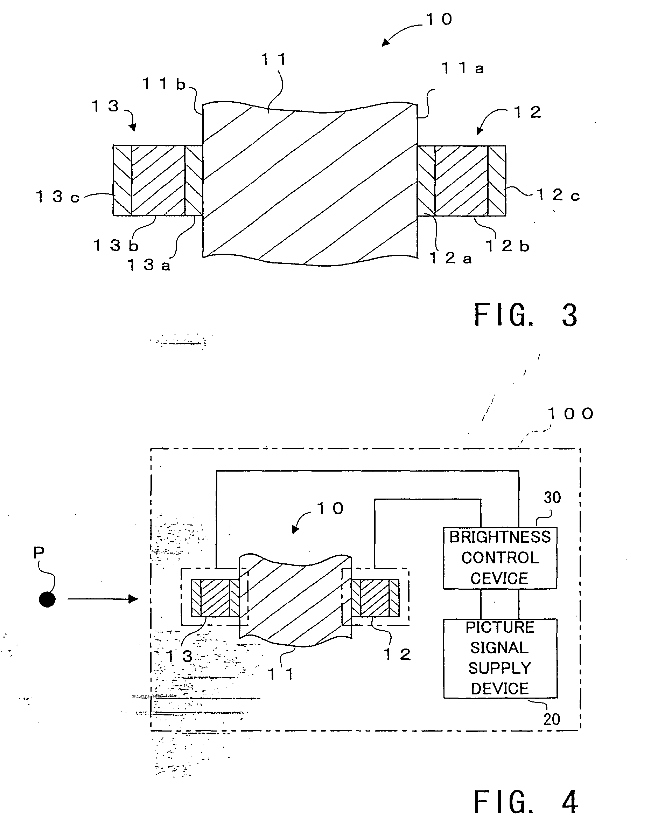

Embodiments of the present invention will now be discussed, with reference to drawings. FIG. 1 is a cross-sectional view of an EL display panel according to an embodiment of the present invention. FIG. 2 is a cross-sectional view enlarged in a part of the EL display panel of FIG. 1. FIG. 3 is a cross-sectional view showing an exemplary construction of an EL device. Incidentally, in FIG. 1 to FIG. 3, each component or element of the embodiment is depicted for an explanation of a technical idea of the present invention, without an intention of limiting or restricting shapes, scales, positions, connection relationships and so on of each component or element. This applies also to FIG. 4 used for an explanation of another embodiment of the invention. Furthermore, for the convenience of explaining the technical idea of the present invention, diaphragms (that are used for a patterning of electrodes) and sealing devices, which are usually provided for the EL display panel, are omitted in FIG. 1 to FIG. 4.

As shown in FIG. 1, an EL display panel 10 according to the embodiment of the present invention is provided with a light transmissive substrate 11, first EL elements 12 disposed on a surface 11a of the substrate 11, and second EL elements 13 disposed on another surface 11b of the substrate 11. Each second EL element 13 is designed to transmit a light therethrough, and arranged oppositely to the first EL element 12 via the substrate 11 disposed therebetween.

Preferably, the first EL elements 12 may be disposed in a number corresponding to the number of pixel assigned to the EL display panel 10 on the surface 11a of the substrate 11 (for the convenience of explanation, three of the first EL element 12 are depicted in FIG. 1). For example, the first EL elements 12 may be preferably disposed on a display area, which is formed on the surface 11a of the substrate 11, in a predetermined arrangement and in the number corresponding to the number of pixel assigned to the EL display panel 10. A function for generating and displaying a 2D (two dimensional) plane image can be achieved by the substrate 11 and the first EL elements 12.

Similarly, the second EL elements 13 may be preferably disposed in a number corresponding to the number of pixel assigned to the EL display panel 10 on the surface 11b of the substrate 11 (for the convenience of explanation, three of the second EL element 13 are depicted in FIG. 1). For example, the second EL elements 13 may preferably be disposed on a display area, which is formed on the surface 11b of the substrate 11, in a predetermined arrangement and in the number corresponding to the number of pixel assigned to the EL display panel 10. A function for generating and displaying a 2D (two dimensional) plane image can be achieved by the substrate 11 and the second EL elements 13.

Each of the second EL elements 13 is designed so as to transmit light as a whole. The substrate 11 is designed so as to transmit light. Thereby, if a viewer views the EL display panel 10 in a direction of an arrow from a view point P in FIG. 1, he/she can see not only an image generated by the second EL elements 13, but also an image generated by the first EL elements 12. That is, the light that is emitted from each first EL element 12 propagates (transmits) through the substrate 11 and the second EL element 13, respectively, to reach at the view point P of the viewer. On the other hand, the light that is emitted from each second EL element 13 reaches directly at the view point P of the viewer.

Furthermore, the first EL elements 12 and the second EL elements 13 are arranged in such a manner that they oppose to each other with an interposition of the substrate 11 therebetween. For example, display areas may be preferably formed respectively on both sides 11a and 11b of the substrate 11 in the same shape and at the same position, and the first EL elements 12 and the second EL elements 13 may be preferably arranged in each display area in the same predetermined arrangement, respectively. Thereby, if the viewer views the EL display panel 10 from the view point P, pixels formed on the surface 11a of the substrate 11 and pixels formed on the surface 11b of the substrate 11 are superimposed. Therefore, if an image display by the first EL elements 12 and an image display by the second EL elements 13 are performed at the same time, the viewer, who views the EL display panel 10 from the view point P, sees an image that is obtained by superimposing the image displayed by the first EL elements 12 and the image displayed by the second EL elements 13. That is, as shown in FIG. 2, because a propagation path of the light that is emitted from each first EL element 12 and is transmitted to propagate through the substrate 11 and the second EL element 13 corresponds to a propagation path of the light that is emitted from each second EL elements 13, the light emitted from each first EL element 12 and the light emitted from each second EL element 13 are superimposed to reach at the view point P of the viewer.

According to the EL display panel 10 constructed as such, images in which the same object are depicted are displayed at the same time by the first EL elements 12 and the second EL elements 13, respectively, and luminance or brightness of one or both images may be changed for each pixel in accordance with depth of the depicted object for example, and thereby a 3D solid or stereoscopic image can be generated and displayed.

That is, as mentioned above, a conventional 3D display apparatus is provided with (i) two image display devices (e.g. two display panels) and (ii) an optical device (e.g. a half mirror) for superimposing images that are displayed respectively on these image display devices. These image display devices and the optical device are independent of each other. On the contrary, the EL display panel 10 according to this embodiment is provided with the substrate 11 and the first and second EL elements 12 and 13 that are formed integrally on both sides of the substrate 11. That is, the EL display panel 10 has the integral construction that embodies the similar functions of the two image display devices and the optical device. Particularly, the opposing arrangement of the first and second EL elements 12 and 13 with the interposition of the substrate 11 therebetween eliminates a necessary to dispose separately a special device (e.g. a half mirror) for superimposing two images.

According to the EL display panel 10 in this embodiment, the integral construction in that the first and second EL elements 12 and 13 are formed on each side of the substrate 11, respectively, presents a smaller and lighter construction to realize the 3D stereoscopic image generation/display, and further presents a reduction in the manufacture cost.

Furthermore, the EL display panel 10 in this embodiment has the integral construction in that the first and second EL elements 12 and 13 are formed on each side of the substrate 11, respectively. Therefore, once the first and second EL elements 12 and 13 are positioned in right places on the surfaces 11a and 11b of the substrate 11 in a manufacturing process of the EL display panel 10, the opposing arrangement of the first and second EL elements 12 and 13 are fixed. By positioning and fixing the first and second EL elements 12 and 13, the arrangement of the pixels is accurately determined, and it is not moved in the future. Therefore, unlike the conventional 3D display apparatus, a concern is eliminated about a misalignment in assembling two display panels into the display apparatus. Therefore, accuracy in assembling the display panel into the display apparatus can be alleviated, resulting in the easier manufacturing. Furthermore, the yield is improved. Additionally, accuracy of the 3D stereoscopic image can be improved.

Incidentally, the first and second EL elements 12 and 13 may be organic electroluminescence elements or may be inorganic electroluminescence elements, and not limited in their structures or constructions. For example, as shown in FIG. 3, the first EL element 12 may be arranged so as to include an electrode 12a having a light transmissive property disposed on the surface 11a of the substrate 11, an EL layer 12b disposed on the electrode 12a and an electrode 12c disposed on the EL layer 12b.

On the other hand, as shown in FIG. 3, the second EL element 13 may be arranged so as to include an electrode 13a having a light transmissive property disposed on the surface 11b of the substrate 11, an EL layer 13b disposed on the electrode 13a and an electrode 13c having a light transmissive property disposed on the EL layer 13b.

In this case, the electrode having the light transmissive property may be made of an IZO (Indium Zinc Oxide), an ITO (Indium Tin Oxide) or the like. Generally, materials for organic EL are not durable so much to heat, and therefore ITO is preferred to the IZO as the electrode having the light transmissive property to be formed on the organic EL layer, because the ITO can be formed at lower temperature than temperature at which IZO can be formed. Therefore, the electrode 13c of the second EL element 13 may be preferably made of the ITO.

The substrate 11 may be made of glass or transparent plastic, which give a light transmissive property.

On the other hand, in order to generate/display the 3D stereoscopic image in such a manner that two images in each of which the common object is depicted are superimposed to each other to be displayed, and then the brightness or luminance of one or both images is controlled in accordance with the depth of the object, it is required not only to superimpose one image and another image but also to control appropriately a distance between a display position of one image and a display position of another image. In the case that the substrate 11 is made of glass or transparent plastic, a value obtained by multiplying n by d (wherein d is thickness of the substrate 11, and n is refractive index of the substrate 11) may be preferably 5 mm or more, specifically may be preferably 7 mm. Thus, by defining the thickness d of the substrate 11 to a predetermined thickness in relation to the refractive index, the distance between the display positions of two images can be determined appropriately. Furthermore, the distance between the display positions of two images is fixed as the thickness of the substrate 11, and it is not changed in the future. Therefore, unlike the conventional 3D display apparatus, a concern is eliminated about a misalignment in assembling two display panels into the display apparatus. Therefore, accuracy in assembling the display panel into the display apparatus can be alleviated, resulting in the easier manufacturing. Furthermore, the yield is improved. Additionally, accuracy of the 3D stereoscopic image can be improved.

Alternatively, the substrate 11 may be formed of a lens array. In this arrangement, the thickness of the substrate 11 can be further reduced, which presents a smaller and lighter 3D display apparatus. Incidentally, in the case that the substrate 11 is formed of the lens array, it is not necessary to dispose the first and second EL elements 12 and 13 oppositely to each other. In this case, a geometric relationship between the first EL elements 12 and the second EL elements 13 can be determined, taking account of the refraction or the like by the lens array, such that the viewer, who views the EL display panel 10 from the view point P, sees an image that is obtained by superimposing an image generated by the first EL elements 12 and an image generated by the second EL elements 13. Alternatively, the substrate 11 may be a substrate having a color change function.

On the other hand, FIG. 4 illustrates a 3D display apparatus according to an embodiment of the present invention. As shown in FIG. 4, the 3D display apparatus 100 according to the embodiment of the present invention is provided with an EL display panel 10 as mentioned above, a picture signal supply device 20 for supplying picture signals to the first and second EL elements 12 and 13 disposed at the EL display panel 10 respectively, and a brightness control device 30 for controlling the brightness of the first or second EL element 12 or 13.

According to the 3D display apparatus 100 constructed as such, the picture signal supply device 20 supplies the picture signals to the first and second EL elements 12 and 13, respectively. Each of the picture signals is for generating/displaying an image in which the common object is depicted. The brightness control device 30 controls the brightness of one or both images generated by the first EL elements 12 and the second EL elements 13, for each pixel for example, in accordance with the depth or the like of the common object depicted in the images. Thereby, if the viewer views the 3D display apparatus 100 from the view point P in FIG. 4, the 3D stereoscopic image is generated/displayed.

Particularly, the display panel disposed at the 3D display apparatus 100 in this embodiment is a single EL display panel 10. Therefore, in comparison to the conventional display apparatus in which two or more individual display panels are disposed, it is possible to provide a smaller and lighter apparatus.

In the 3D display apparatus 100 in this embodiment, the 3D stereoscopic image is generated/displayed by the single EL display panel 10 constructed as a unit body. Therefore, it is possible to superimpose two images with high accuracy and to advantageously maintain the distance between two images depending on the thickness of the substrate 11, resulting in the achievement of the 3D stereoscopic image with high accuracy and reliance.

Moreover, according to the 3D display apparatus 100 in this embodiment, the 3D stereoscopic image is generated/displayed only by the single EL display panel 10 constructed as a unit body. Therefore, unlike the conventional 3D display apparatus, a difficult manufacturing process involving assembling two or more display panels with high accuracy is eliminated. As a result, the manufacturing process is simplified, and the yield is improved.

Incidentally, the EL display panel 10 according to the embodiment of the invention is not limited in its application to the 3D display apparatus. For example, it is possible to dispose the first EL element, which emits yellow light, on one surface 11a of the substrate 11, while the second EL element, which emits blue light, on another surface 11b of the substrate 11, and to supply different picture signals to each of these elements. In this arrangement, the viewer feels white color for a part at which both of the first and second EL elements emit the light, and yellow or blue for a part at which one of the first and second EL elements emits the light. Thereby, an electronic billboard can be achieved for example.

### (Examples)

An example of an EL display panel according to the present invention will now be discussed, with reference to drawings.

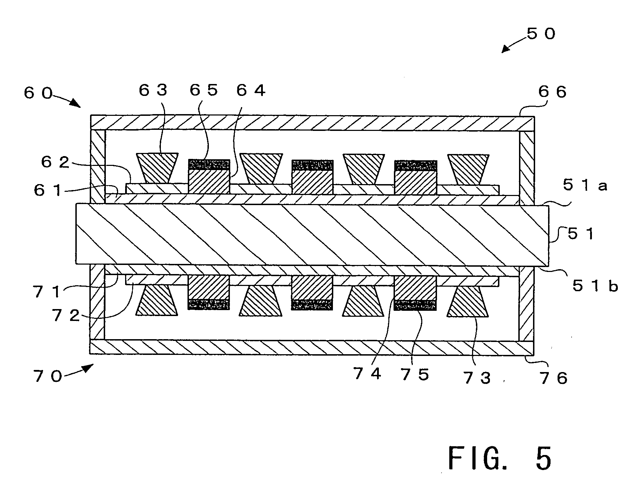

Firstly, a construction of the example of the EL display panel according to the present invention will now be discussed, with reference to FIG. 5. FIG. 5 is a cross-sectional view illustrating the construction of this EL display panel.

As shown in FIG. 5, the EL display panel 50 is provided with a substrate 51, a rear side EL element unit 60 disposed on a rear side surface 51a of the substrate 51, and a front side EL element unit 70 disposed on a front side surface 51b of the substrate 51.

The substrate 51 is made of glass having a light transmissive property. A value obtained by multiplying n by d (wherein d is thickness of the substrate 51, and n is refraction index of the substrate 51) is preferably 5 mm or more, specifically about 7 mm.

The rear side EL element unit 60 includes transparent electrodes 61, insulation layers 62, diaphragms 63, organic EL layers 64, aluminum electrodes (Al electrodes) 65 and a sealing lid 66.

Each transparent electrode 61 are made of IZO (Indium Zinc Oxide) and has a light transmissive property. The transparent electrodes 61 are formed on the rear side surface 51a of the substrate 51. Each transparent electrode 61 is about 100nm in its thickness. Incidentally, the transparent electrodes 61 are arranged on the rear side surface 51a in the direction perpendicular to the paper of the drawing.

The insulation layers 62 are made of polyimide. Each insulation layer 62 is employed for avoiding a current leakage and formed in the area other than the area in which pixels (organic EL's 64) are formed. Each insulation layer 62 is. about 300 nm in its thickness. The diaphragms 63 used for patterning the Al electrodes 65 are formed on the insulation layers 62, respectively.

Each of the organic EL layers 64 includes a hole injection layer (HIL), a hole transport layer (HTL), an emissive layer (EML), an electron transport layer (ETL) and an electron injection layer (EIL). The HIL is made of CuPc (Copper Phthalocyanin), the HTL is made of alpha-NPB (N,N'-Di(naphthalen-1-yl)-N,N'-diphenyl-benzidine), the EML is made of Alq₃ (Tris (8-hydroxy-quinoline) aluminum), the ETL is made of BCP (Bathocuproine) and the EIL is made of LiF (Lithium fluoride), respectively. Each organic EL layer 64 is formed on the transparent electrode 61 and disposed at a position where the pixel is to be formed.

Each Al electrode 65 is made of aluminum, and formed on the organic EL layer 64. The Al electrode is about 100 nm in its thickness.

The sealing lid 66 is made of glass. The sealing lid 66 is formed so as to encapsulate the transparent electrodes 61, the insulation layers 62, the diaphragms 63, the organic EL layers 64 and the Al electrodes 65, in cooperation with the substrate 51; for protecting these components.

On the other hand, the front side EL element unit 70 includes transparent electrodes 71, insulation layers 72, diaphragms 73, organic EL layers 74, ITO electrodes 75 and a sealing lid 76.

Each construction of the transparent electrodes 71, the insulation layers 72, the diaphragms 73, the organic EL layers 74 and the sealing lid 76 are the same respectively as that of the transparent electrodes 61, the insulation layers 62, the diaphragms 63, the organic EL layers 64 and the sealing lid 66, excepting a point that they are disposed on the front side surface 51b of the substrate 51.

Each ITO electrode 75 formed on the organic EL layer 74 is made of ITO (Indium Tin Oxide), and has a light transmissive property.

The display area where the image is to be displayed is formed on each of the rear side surface 51a and the front side surface 51b of the substrate 51. These display areas on the rear side surface 51a and the front side surface 51b are formed in the same shape to each other and disposed in the corresponding position to each other. In each display area, pixels for generating the image to be displayed are arranged, and positions where pixels are to be formed are the same between the rear side surface 51a and the front side surface 51b. Since at least the organic EL layers 64 and 74 are formed at positions where pixels are to be formed on either of the rear side surface 51a and the front side surface 51b, the arrangement or positioning of the organic EL layers 64 and 74 corresponds to each other.

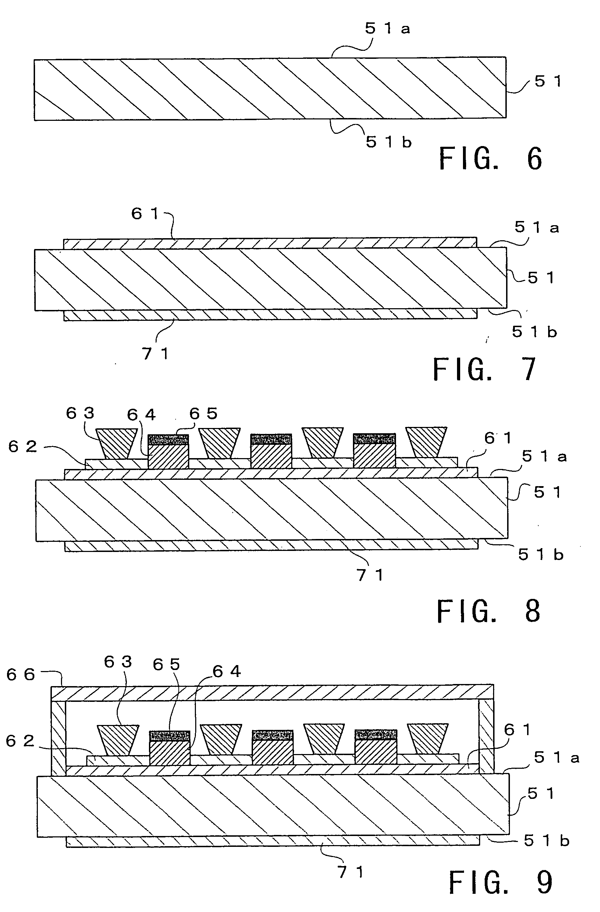

Next, a manufacturing process of the EL display panel 50 will now be discussed, with reference to FIG. 6 to FIG. 9.

In order to manufacture the EL display panel 50, firstly, a predetermined thickness of the substrate 51 is prepared, as shown in FIG. 6.

Next, as shown in FIG. 7, transparent electrodes 61 and 71 are formed respectively on each side of the substrate 51. Specifically, firstly, a patterning is performed on the rear side surface 51a of the substrate 51 by spattering or the like to form the transparent electrodes 61, then the substrate 51 is turned over, and a patterning is performed on the front side surface 51b of the substrate 51 by spattering or the like to form the transparent electrodes 71. Thus, since not only the transparent electrodes 61 but also the transparent electrodes 71 are formed prior to forming the organic EL layers 64, damage to the organic EL layers 64 that may be caused by heat generated during the formation of transparent electrodes 61 and 71 can be avoided.

Next, the insulation layers 62, the diaphragms 63, the organic EL layers 64, and the Al electrodes 65 are formed on the rear side surface 51a of the substrate 51, as shown in FIG. 8. These components can be formed in well-known manners. For example, firstly, the insulation layers 62 are patterned on the parts other than the parts where pixels are to be formed, and then the diaphragms 63 are formed on the insulation layers 62. Next, the organic EL layers 64 are deposited in a vacuum evaporation method using a pattern mask, and the Al electrodes 65 are deposited on the organic EL layers 64 in a vacuum evaporation method. The Al electrodes 65 can be patterned by using the diaphragms 63, so that a mask is not used to form the Al electrodes 65.

Next, as shown in FIG. 9, the sealing lid 66 is formed so as to encapsulate the transparent electrodes 61, the insulation layers 62, the diaphragms 63, the organic EL layers 64 and the Al electrodes 65 on the rear side surface 51a of the substrate 51. Since the sealing lid 66 is formed on the rear side surface 51b prior to forming the insulation layer 72, the diaphragms 73, the organic EL layers 74 and the ITO electrodes 75 on the front side surface 51b of the substrate 51, damage to the transparent electrodes 61, the insulation layers 62, the diaphragms 63, the organic EL layers 64 and the Al electrodes 65 that may be caused by heat generated during the formation of the insulation layers 72, the diaphragms 73, the organic EL layers 74 and the ITO electrodes 75 can be avoided.

Next, the substrate 51 on which the transparent electrodes 61, the insulation layers 62, the diaphragms 63, the organic EL layers 64, the Al electrodes 65 and the sealing lid 66 are already formed is turned over, and then the insulation layers 72, the diaphragms 73, the organic EL layers 74 and the ITO electrodes 75 are formed on the front side surface 51b of the substrate 51. These components 72 to 75 can be formed in a similar manner to that of the insulation layers 62, the diaphragms 63, the organic EL layers 64 and the sealing lid 66. On the other hand, the ITO electrodes 75 are formed on the organic EL layers 74 in a spattering method. At this time, the patterning is performed by using the diaphragms 73.

Through the aforementioned process, the EL display apparatus 50 as shown in FIG. 5 is completed. In the EL display apparatus 50 of this example, at least the organic EL layers 64 and the organic EL layers 74 correspond to each other in their arrangement or positioning. For this, a pattern mask to be used for forming the organic EL layers 64 and a pattern mask to be used for forming the organic EL layers 74 are prepared, taking account into the correspondence between the arrangements of the organic EL layers 64 and 74. If the arrangement of the organic EL layer 64 or 74 is symmetric vertically or horizontally, a common pattern mask can be used for forming each of the organic EL layers 64, 74.

As mentioned above, an optical system for embodying the 3D stereoscopic image can be implemented as a single display panel constructed as unit body, owing to the construction in which (i) the rear side EL element unit 60 and the front side EL element unit 70 are disposed on either side of the substrate 51, (ii) the substrate 51 and the electrodes 61, 71 and 75 are made of light transmissive materials, and (iii) at least the organic EL layers 64 and 74 correspond to each other in their arrangement or positioning.

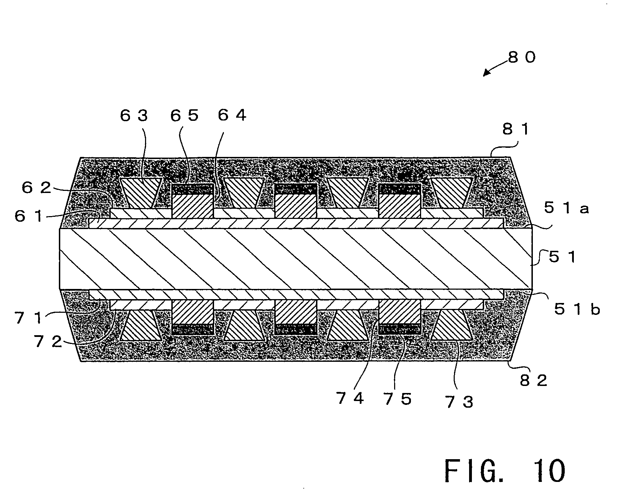

Incidentally, in the aforementioned example, the sealing lids 66 and 76 are employed to protect the organic EL layers 64, 74, the electrodes 61, 65, 71 and 75, nevertheless, the present invention is not limited to this example. For example, as an EL display panel 80 shown in FIG. 10, protective layers 81 and 82 may be disposed on either side of the substrate 51 so as to embed components such as organic EL layers 64 and 74, electrodes 61, 65, 71 and 75 or the like therein.

## Claims

1. An electroluminescence display panel (10) **characterized in that** the electroluminescence display panel comprises:
a substrate (11) having a light transmissive property and having a first surface (11a) and a second surface (11b), the second surface being opposite to the first surface;
a first electroluminescence element (12) disposed on the first surface of the substrate; and
a second electroluminescence element (13) disposed on the second surface of the substrate,
wherein the second electroluminescence element is formed so as to transmit light, and positioned in a place opposite to the first electroluminescence element.

2. The electroluminescence display panel (10) according to claim 1, **characterized in that** the first electroluminescence element (12) comprises:
a first electrode (12a) disposed on the first surface (11a) of the substrate (11) and having a light transmissive property;
an electroluminescence layer (12b) disposed on the first electrode; and
a second electrode (12c) disposed on the electroluminescence layer.

3. The electroluminescence display panel (10) according to claim 1 or 2, **characterized in that** the second electroluminescence element (13) comprises:
a first electrode (13a) disposed on the second surface (11b) of the substrate (11) and having a light transmissive property;
an electroluminescence layer (13b) disposed on the first electrode; and
a second electrode (13c) disposed on the electroluminescence layer and having a light transmissive property.

4. The electroluminescence display panel (10) according to claim 3, **characterized in that** the second electrode (13c) of the second electroluminescence element (13) is made of IZO (Indium Zinc Oxide).

5. The electroluminescence display panel (10) according to any one of claims 1 to 4, **characterized in that** light emitted from the first electroluminescence element (12) propagates through the substrate (11) and the second electroluminescence element (13).

6. The electroluminescence display panel (10) according to any one of claims 1 to 5, **characterized in that** a propagation path of light that is emitted from the first electroluminescence element (12) and then propagates through the substrate (11) and the second electroluminescence element (13) overlaps with a propagation path of light that is emitted from the second electroluminescence element (13).

7. The electroluminescence display panel (10) according to any one of claims 1 to 6, **characterized in that** a display area is formed in each of the first surface (11a) and the second surface (11b) of the substrate (11),
a plurality of the first electroluminescence element (12) are disposed in a predetermined arrangement in the display area formed on the first surface of the substrate,
a plurality of the second electroluminescence element (13) are disposed in a predetermined arrangement in the display area formed on the second surface of the substrate, and
each of the plurality of the first electroluminescence element formed on the first surface of the substrate and each of the plurality of the second electroluminescence element formed on the second surface of the substrate are in an opposite relationship to each other.

8. The electroluminescence display panel (10) according to any one of claims 1 to 7, **characterized in that** the substrate (11) is made of glass.

9. The electroluminescence display panel (10) according to any one of claims 1 to 7, **characterized in that** said substrate (11) is made of transparent plastic.

10. The electroluminescence display panel (10) according to any one of claims 1 to 9, **characterized in that** a value obtained by multiplying "n" by "d", wherein "n" is refraction index of the substrate (11) and "d" is thickness of the substrate, is not less than 5mm.

11. The electroluminescence display panel (10) according to any one of claims 1 to 9, **characterized in that** said substrate (11) is a lens array.

12. A three-dimensional display apparatus (100) **characterized in that** the three dimensional display apparatus comprises:
an electroluminescence display panel (10) including: a substrate (11) having a light transmissive property and having a first surface (11a) and a second surface (11b) that is opposite to the first surface, a first electroluminescence element (12) disposed on the first surface of the substrate, and a second electroluminescence element (13) disposed on the second surface of the substrate, the second electroluminescence element being formed so as to transmit light and positioned in a place opposite to the first electroluminescence element;
a picture signal supply device (20) for supplying picture signals to the first electroluminescence element and the second electroluminescence element of the electroluminescence display panel, respectively; and
a brightness control device (30) for controlling brightness of the first electroluminescence element or the second electroluminescence element.
